# EUROPEAN PATENT APPLICATION

(11) **EP 4 261 610 A1**
(43) Date of publication of application: **18.10.2023**
(21) Application number: 21903340.4
(22) Date of filing: 03.12.2021
(51) Int. Cl.: G03B 13/36, H04N 5/225, G01S 7/481, G02B 6/35, G02B 7/40

(54) **ELECTROMAGNETIC WAVE DETECTION DEVICE AND ELECTROMAGNETIC WAVE DETECTION METHOD**

(30) Priority: 08.12.2020 JP 2020203689
(71) Applicant: Kyocera Corporation, Kyoto-shi Kyoto 612-8501 (JP)
(72) Inventor: OKADA Hiroki, Kyoto-shi, Kyoto 612-8501 (JP); HOSHINO Koichi, Kyoto-shi, Kyoto 612-8501 (JP)
(74) Representative: Viering, Jentschura & Partner mbB Patent- und Rechtsanwälte
(86) International application number: PCT/JP2021/044563
(87) International publication number: WO 2022/124237

(57) **Abstract**

An electromagnetic wave detection apparatus includes a radiation unit, a first detection module, a propagation module, and a control unit. The radiation unit is configured to emit an electromagnetic wave. The first detection module includes a plurality of detection elements configured to output result denoting detection of an electromagnetic wave. The propagation module includes a plurality of propagation elements capable of switching between a first state and a second state. The electromagnetic wave is caused to proceed toward the first detection module by the plurality of propagation elements in the first state and is kept from proceeding toward the first detection module by the plurality of propagation elements in the second state. The control unit is configured to cause a first propagation element to transition into the first state and to cause a second propagation element to transition into the second state. The electromagnetic wave proceeds into the first propagation element and dose not proceed into the second propagation element. The control unit is configured not to determine, based on detection result output by at least one of the plurality of detection elements into which the electromagnetic wave does not proceed, the detection of the electromagnetic wave.

## Description

### CROSS-REFERENCE TO RELATED APPLICATION

The present application claims priority to Japanese Patent Application No. 2020-203689, filed on December 8, 2020, the content of which is incorporated by reference herein in its entirety.

### TECHNICAL FIELD

The present disclosure relates to an electromagnetic wave detection apparatus and an electromagnetic wave detection method.

### BACKGROUND OF INVENTION

A known configuration enables the changing of the propagation direction of electromagnetic waves with the objective of detecting electromagnetic waves proceeding in a predetermined direction (see, for example, Patent Literature 1).

### CITATION LIST

### PATENT LITERATURE

Patent Literature 1: Japanese Unexamined Patent Application Publication No. 2018-200927

### SUMMARY

According to an embodiment of the present disclosure, an electromagnetic wave detection apparatus includes a radiation unit, a first detection module, a propagation module, and a control unit. The radiation unit is configured to emit an emission electromagnetic wave to a space in which a detection target is present. The first detection module includes a plurality of detection elements configured to output result denoting detection of a reflected electromagnetic wave generated by return of the emission electromagnetic wave from the detection target. The propagation module includes a plurality of propagation elements capable of switching between a first state and a second state. The reflected electromagnetic wave is caused to proceed toward the first detection module by the plurality of propagation elements in the first state and is kept from proceeding toward the first detection module by the plurality of propagation elements in the second state. The control unit is configured to cause a first propagation element included in the plurality of propagation elements to transition into the first state and to cause a second propagation element included in the plurality of propagation elements to transition into the second state. The reflected electromagnetic wave proceeds into the first propagation element and does not proceed into the second propagation element. The control unit is configured to determine, based on detection result output by at least one of the plurality of detection elements into which the reflected electromagnetic wave proceeds, the detection of the reflected electromagnetic wave. The control unit is configured not to determine, based on detection result output by at least one of the plurality of detection elements into which the reflected electromagnetic wave does not proceed, the detection of the reflected electromagnetic wave.

According to an embodiment of the present disclosure, an electromagnetic wave detection apparatus includes a radiation unit, a first detection module, and a control unit. The radiation unit is configured to emit an emission electromagnetic wave to a space in which a detection target is present. The first detection module includes a plurality of detection elements configured to output result denoting detection of an electromagnetic wave incident from the space. The control unit is configured to determine, based on detection result output by at least one of the plurality of detection elements into which a reflected electromagnetic wave generated by return of the emission electromagnetic wave from the detection target proceeds, the detection of the reflected electromagnetic wave. The control unit is configured not to determine, based on detection result output by at least one of the plurality of detection elements into which the reflected electromagnetic wave does not proceed, the detection of the reflected electromagnetic wave.

According to an embodiment of the present disclosure, an electromagnetic wave detection method includes emitting an emission electromagnetic wave to a space in which a detection target is present. The electromagnetic wave detection method includes causing a plurality of propagation elements included in a propagation module to undergo switching between two states. The propagation module is configured to cause a reflected electromagnetic wave generated by return of the emission electromagnetic wave from the detection target to proceed toward a first detection module including a plurality of detection elements and configured to detect the reflected electromagnetic wave. The electromagnetic wave detection method includes causing a first propagation element included in the plurality of propagation elements to transition into a first state in which the reflected electromagnetic wave is caused to proceed toward the first detection module. The electromagnetic wave detection method includes causing a second propagation element included in the plurality of propagation elements to transition into a second state in which the reflected electromagnetic wave is kept from proceeding toward the first detection module. The reflected electromagnetic wave proceeds into the first propagation element and does not proceed into the second propagation element. The electromagnetic wave detection method includes determining, based on detection result output by at least one of the plurality of detection elements into which the reflected electromagnetic wave proceeds, detection of the reflected electromagnetic wave. The electromagnetic wave detection method includes not determining, based on detection result output by at least one of the plurality of detection elements into which the reflected electromagnetic wave does not proceed, the detection of the reflected electromagnetic wave.

According to an embodiment of the present disclosure, an electromagnetic wave detection method includes emitting an emission electromagnetic wave to a space in which a detection target is present. The electromagnetic wave detection method includes: determining, based on detection result output by at least one of a plurality of detection elements included in a first detection module configured to detect an electromagnetic wave incident from the space, detection of a reflected electromagnetic wave generated by return of the emission electromagnetic wave from the detection target when the reflected electromagnetic wave proceeds into the at least one of the plurality of detection elements; and not determining, based on detection result output by at least one of the plurality of detection elements into which the reflected electromagnetic wave does not proceed, the detection of the reflected electromagnetic wave.

### BRIEF DESCRIPTION OF THE DRAWINGS

FIG. 1 illustrates an example configuration of an electromagnetic wave detection apparatus according to an embodiment.
FIG. 2 illustrates an example configuration of a detection unit.
FIG. 3 illustrates an example of the correspondence between propagation elements and detection elements.
FIG. 4 illustrates an example of the correspondence between the incident point of a reflected electromagnetic wave and the state of propagation elements and detection elements.
FIG. 5 is a table denoting the relationship between the orientation of a reflecting surface of a radiation unit, driving signals, detection elements, and propagation elements.
FIG. 6 is a flowchart of an example procedure adopted into an adjustment method according to an embodiment.
FIG. 7 illustrates an example in which a switch enables and disables output from each detection element.
FIG. 8 illustrates an example in which microlenses cause incoming electromagnetic waves to converge into the respective detection elements.

### DESCRIPTION OF EMBODIMENTS

When multiple detection elements are used to detect electromagnetic waves propagating from a detection target (a subject or object to be detected), noise can occur in one or more detection elements into which the electromagnetic waves from the detection target does not proceed. For this reason, greater imperviousness to noise is being called for.

The objective of the present disclosure is to provide an electromagnetic wave detection apparatus and an electromagnetic wave detection method that enhance the imperviousness to noise occurring in one or more detection elements into which an electromagnetic wave from a detection target does not proceed.

An embodiment of the present disclosure will be described in detail below with reference to the accompanying drawings. The drawings that will be mentioned in the following description are schematic representations. Constituent elements are not drawn to scale, and the dimension ratios thereof do not necessarily fully correspond to the actual dimension ratios.

### (Example Configuration of Electromagnetic Wave Detection Apparatus 10)

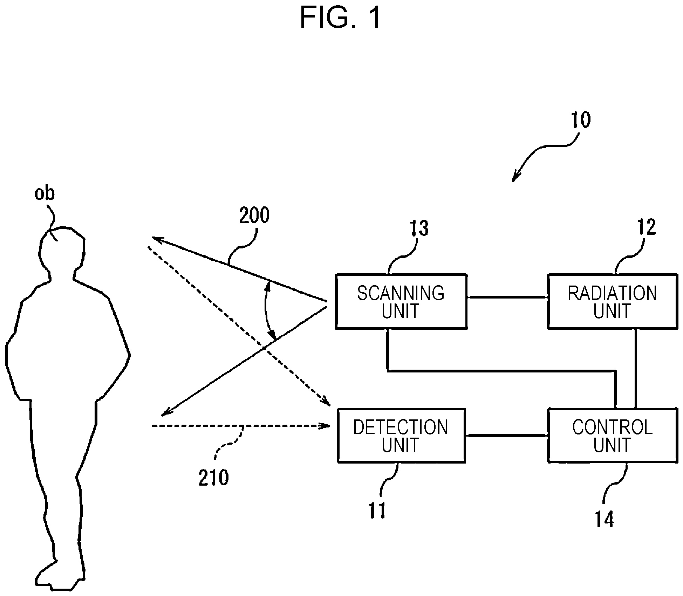

Referring to FIG. 1, an electromagnetic wave detection apparatus 10 according to an embodiment includes a detection unit 11, a radiation unit 12, a scanning unit 13, and a control unit 14. The electromagnetic wave detection apparatus 10 or, more specifically, the radiation unit 12 radiates an electromagnetic wave. The scanning unit 13 changes the propagation direction of the electromagnetic wave radiated by the radiation unit 12 such that the electromagnetic wave is radiated into the space in which the detection target ob is present. The detection target ob is scanned with the electromagnetic wave radiated into the space while the propagation direction of the electromagnetic wave is changed by the scanning unit 13. The electromagnetic wave emitted toward the detection target ob is denoted by solid lines in FIG. 1 and is hereinafter also referred to as an emission electromagnetic wave 200. The propagation direction of the emission electromagnetic wave 200 is hereinafter also referred to as an emission direction. The emission electromagnetic wave 200 is at least partially reflected by the detection target ob and proceeds toward the detection unit 11. The electromagnetic wave reflected by the detection target ob is then at least partially detected by the detection unit 11. Accordingly, the electromagnetic wave detection apparatus 10 acquires information about the detection target ob. The electromagnetic wave generated by the return of the emission electromagnetic wave 200 from the detection target ob is denoted by broken lines and is hereinafter also referred to as a reflected electromagnetic wave 210.

The control unit 14 controls the radiation unit 12 and the scanning unit 13 to select a direction in which the electromagnetic wave will be emitted. That is, the control unit 14 causes the electromagnetic wave from the radiation unit 12 to propagate in a predetermined direction. The emission electromagnetic wave 200 incident on the detection target ob reaches a predetermined part of the detection target ob and is reflected by the detection target ob. The resultant wave, namely, the reflected electromagnetic wave 210 proceeds towards the detection unit 11. The control unit 14 causes the detection unit 11 to detect the reflected electromagnetic wave 210 generated from the emission electromagnetic wave 200 incident on a predetermined part of the detection target ob. Accordingly, the control unit 14 acquires information about the predetermined part of the detection target ob. That is, the control unit 14 selects a direction in which the emission electromagnetic wave 200 will be emitted. Accordingly, the control unit 14 acquires information about a region of interest in the detection target ob. With the detection target ob being scanned with the emission electromagnetic wave 200, the information about the detection target ob is acquired in the form of a two-dimensional mapping by the control unit 14.

The constituent units of the electromagnetic wave detection apparatus 10 will be described in detail below.

### <Control Unit 14>

The control unit 14 includes at least one processor and memory. The control unit 14 may include a general-purpose processor and/or a purpose-built processor. The general-purpose processor fetches specific programs to perform specific functions. The purpose-built processor is tailored to a specific processing. The purpose-built processor may include an application-specific integrated circuit (ASIC). The at least one processor may include a programmable logic device (PLD). The PLD may include a field-programmable gate array (FPGA). The control unit 14 may include a system-on-a-chip (SoC) and/or a system-in-a-package (SiP) integrating one or more processors configured to work in cooperation.

### <Radiation Unit 12 and Scanning Unit 13>

The radiation unit 12 radiates an electromagnetic wave. The radiation unit 12 may emit at least one of infrared light, visible light, ultraviolet light, or a radio wave. The radiation unit 12 may include a light-emitting diode (LED), a laser diode (LD), or the like.

The scanning unit 13 changes the propagation direction of the electromagnetic wave radiated by the radiation unit 12 such that the detection target ob is scanned with the electromagnetic wave. The scanning unit 13 may have a scanning reflecting surface that reflects the electromagnetic wave radiated by the radiation unit 12 and may change the orientation of the scanning reflecting surface to scan a detection target ob with the electromagnetic wave. The scanning unit 13 may include at least one of a MEMS mirror, a polygon mirror, or a galvanometer mirror. The scanning unit 13 may be included in the radiation unit 12.

The radiation unit 12 may scan the detection target ob with an electromagnetic wave by performing phased scanning that enables the changing of the emission direction of an electromagnetic wave through the control of the phase of the electromagnetic wave. In this case, the scanning unit 13 of the electromagnetic wave detection apparatus 10 is optional.

### <Detection Unit 11>

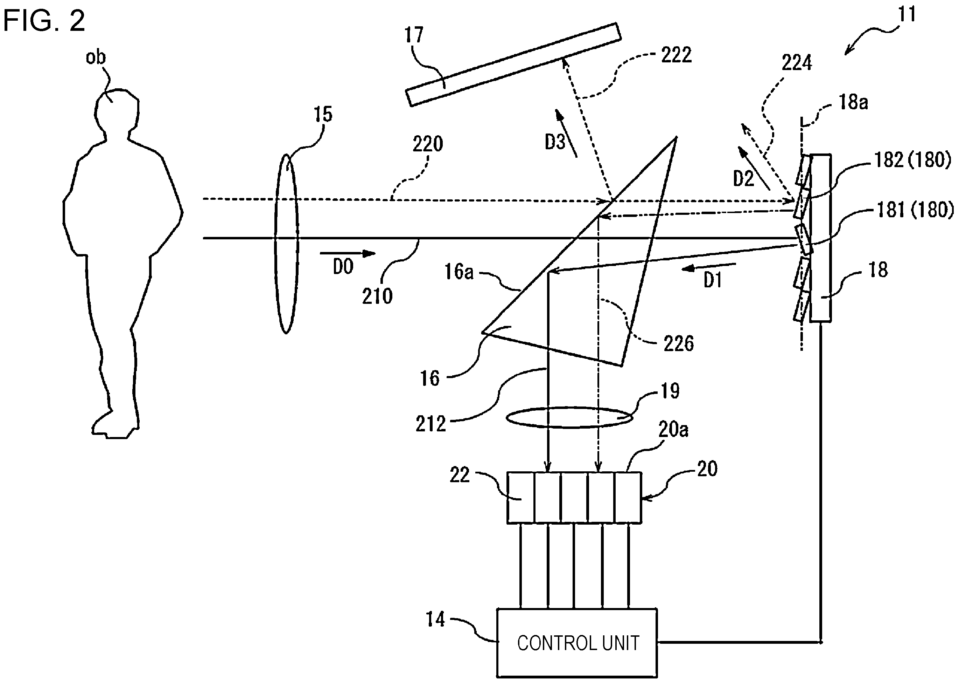

Referring to FIG. 2, the detection unit 11 includes a propagation module 18 and a first detection module 20.

The propagation module 18 includes multiple propagation elements 180, which are arranged along a reference plane 18a. The propagation elements 180 are each capable of switching between two different states in which the reflected electromagnetic wave 210 proceeds in the respective directions. One of the two different states is a first state in which the propagation elements 180 cause an incoming electromagnetic wave (e.g., the reflected electromagnetic wave 210) to proceed toward the first detection module 20. The other state is a second state in which the propagation elements 180 cause an incoming electromagnetic wave (e.g., the reflected electromagnetic wave 210) to veer away from the first detection module 20. That is, the propagation elements 180 are each capable of switching between the first state and the second state.

The control unit 14 selects between the first state and the second state for each of the propagation elements 180. Accordingly, the control unit 14 controls the propagation direction of the reflected electromagnetic wave 210 incident on the propagation elements 180. Each propagation element 180 in the first state is hereinafter referred to as a first propagation element 181. Each propagation element 180 in the second state is hereinafter referred to as a second propagation element 182.

Referring to FIG. 2, the reflected electromagnetic wave 210 is denoted by a solid arrow. The propagation direction of the reflected electromagnetic wave 210 proceeding toward the propagation module 18 is denoted by D0. In a case where the reflected electromagnetic wave 210 is incident on any of the first propagation elements 181, the propagation direction of the reflected electromagnetic wave 210 is changed to a direction D1 by the first propagation element 181. When the propagation direction of the reflected electromagnetic wave 210 is changed by the first propagation element 181, the reflected electromagnetic wave 210 proceeds toward the first detection module 20 and is hereinafter referred to as a first detection electromagnetic wave 212.

Electromagnetic waves from the space in which the detection target ob is present can proceed into the detection unit 11. As with the reflected electromagnetic wave 210, a background electromagnetic wave 220 can proceed into the detection unit 11. The background electromagnetic wave 220 from the detection target ob or from the background of the detection target ob proceeds into the detection unit 11, irrespective of the emission direction of the emission electromagnetic wave 200. The background electromagnetic wave 220 may be light emitted by a light source (e.g., the sun) or light emitted by a light source and reflected by the detection target ob. The background electromagnetic wave 220, which is denoted by a dotted arrow, proceeds into the detection unit 11. In a case where the background electromagnetic wave 220 proceeds in the direction D0 and is incident on any of the second propagation elements 182, the propagation direction of the background electromagnetic wave 220 is changed to a direction D2 by the second propagation element 182. The background electromagnetic wave 220 incident on the second propagation element 182 may proceed toward the outside of the detection unit 11 and may be hereinafter referred to as an undetected electromagnetic wave 224. In a case where the reflected electromagnetic wave 210 is incident on any of the second propagation elements 182, the propagation direction of the reflected electromagnetic wave 210 is changed to the direction D2 by the second propagation element 182.

The background electromagnetic wave 220 incident on the second propagation element 182 may partially proceed into the first detection module 20 due to, for example, scattering in the propagation module 18 and may be hereinafter referred to as a noise electromagnetic wave 226. The noise electromagnetic wave 226 is denoted by a dash-dot-dot arrow.

The first detection module 20 includes multiple detection elements 22, which are arranged along a detection surface 20a. The first detection electromagnetic wave 212 (the reflected electromagnetic wave 210) from the first propagation element 181 of the propagation module 18 is incident on at least one of the detection elements 22. The first detection electromagnetic wave 212 is detected by the detection element 22, which in turn outputs the detection result to the control unit 14. The detection element 22 may determine the intensity of the first detection electromagnetic wave 212 and may output the result to the control unit 14. Accordingly, the control unit 14 receives the detection result from the detection element 22.

The first detection module 20 is an active sensor that detects the reflected electromagnetic wave 210. The emission electromagnetic wave 200 is emitted toward the detection target ob by the radiation unit 12 or the scanning unit 13, and the reflected electromagnetic wave 210 is generated by the return of the emission electromagnetic wave 200 from the detection target ob.

The detection unit 11 may further include a prism 16 and a second detection module 17. The prism 16 has a reflecting surface 16a. The reflected electromagnetic wave 210 proceeding into the detection unit 11 strikes on the reflecting surface 16a from the outside of the prism 16. The reflected electromagnetic wave 210 at least partially passes through the reflecting surface 16a and proceeds toward the propagation module 18. The reflected electromagnetic wave 210 may be at least partially reflected by the reflecting surface 16a and may proceed into the second detection module 17. The first detection electromagnetic wave 212 is incident on the reflecting surface 16a from the inside of the prism 16 and is then reflected by the reflecting surface 16a to proceed toward the first detection module 20.

The background electromagnetic wave 220 proceeding into the detection unit 11 strikes on the reflecting surface 16a from the outside of the prism 16. The background electromagnetic wave 220 may be at least partially reflected by the reflecting surface 16a and may proceed into the second detection module 17. The electromagnetic wave concerned is hereinafter referred to as a second detection electromagnetic wave 222. The background electromagnetic wave 220 is detected by the second detection module 17. The second detection module 17 may take in imagery formed by the second detection electromagnetic wave 222 (the background electromagnetic wave 220 reflected).

The detection unit 11 may further include a first image-forming module 15. The first image-forming module 15 is configured to cause the reflected electromagnetic wave 210 proceeding into the propagation module 18 to form imagery on the reference plane 18a of the propagation module 18. The first image-forming module 15 is also configured to cause the background electromagnetic wave 220 proceeding into the second detection module 17 to form imagery on a detection surface of the second detection module 17. Conversely, the reference plane 18a of the propagation module 18 and the detection surface of the second detection module 17 are each placed at an image point of the first image-forming module 15.

The first image-forming module 15 causes an incident electromagnetic wave to form imagery on the reference plane 18a. The first image-forming module 15 may be an optical member whose image point is on the reference plane 18a. The first image-forming module 15 may be an optical member including a lens and/or a mirror.

The detection unit 11 may further include a second image-forming module 19. The second image-forming module 19 is configured to cause the first detection electromagnetic wave 212 proceeding into the first detection module 20 to form imagery on the detection elements 22 or, more specifically, on the detection surface 20a of the first detection module 20. Conversely, the detection elements 22 of the first detection module 20 are each placed at an image point of the second image-forming module 19.

### (Example of Operation of Electromagnetic Wave Detection Apparatus 10)

The control unit 14 controls the radiation unit 12 or the scanning unit 13 as well as the propagation module 18 and the first detection module 20 to acquire information about the detection target ob. The control may be performed in the following manner.

The control unit 14 controls the radiation unit 12 to cause the radiation unit 12 to emit an electromagnetic wave. The control unit 14 may control the scanning unit 13 in such a manner that the emission electromagnetic wave 200 is emitted to a predetermined part of the detection target ob. The control unit 14 causes the detection unit 11 to detect the reflected electromagnetic wave 210 generated by reflection of the emission electromagnetic wave 200 on the predetermined part of the detection target ob. Accordingly, the control unit 14 acquires information about the predetermined part of the detection target ob. The space in which the detection target ob is present is scanned with the emission electromagnetic wave 200. Accordingly, the control unit 14 acquires the information about the detection target ob that spans over a wide range in the space.

The reflected electromagnetic wave 210 proceeds into at least one of the propagation elements 180 of the propagation module 18. The background electromagnetic wave 220 proceeds into the propagation element 180 concurrently with the reflected electromagnetic wave 210. The propagation elements 180 toward which the reflected electromagnetic wave 210 proceeds are caused to transition into the first state in advance by the control unit 14. The reflected electromagnetic wave 210 incident on the propagation element 180 caused to transition into the first state is directed toward the first detection module 20. The propagation elements 180 into which the reflected electromagnetic wave 210 does not proceed are caused to transition into the second state by the control unit 14. The propagation elements 180 into which the reflected electromagnetic wave 210 does not proceed are caused to transition into the second state. When electromagnetic waves other than the reflected electromagnetic wave 210 proceed into the propagation module 18 in the second state, the relevant propagation elements 180 cause the incoming electromagnetic waves to veer away from the first detection module 20. For example, the background electromagnetic wave 220, which is different from the reflected electromagnetic wave 210, is incident on the second propagation element 182 and then proceeds in the direction D2. The electromagnetic wave proceeding in the direction D2 mostly does not proceed into the first detection module 20 and is thus regarded as the undetected electromagnetic wave 224. The second propagation element 182 may cause the undetected electromagnetic wave 224 to proceed in the direction D2 and to go out of the detection unit 11 accordingly.

Each propagation element 180 is caused to transition into the first state or the second state as described above. This feature reduces the possibility that electromagnetic waves other than the reflected electromagnetic wave 210 will be detected by the first detection module 20 and will cause noise. The background electromagnetic wave 220 mostly does not proceed into the first detection module 20. In some cases, however, the background electromagnetic wave 220 incident on the second propagation element 182 partially proceeds into the first detection module 20 as a scattering component. The background electromagnetic wave 220 proceeding into the first detection module 20 can cause noise that interferes with the detection of the reflected electromagnetic wave 210 in the first detection module 20.

The control unit 14 is configured to determine the detection of the reflected electromagnetic wave 210 on the basis of the detection result output by the detection elements 22 into which the first detection electromagnetic wave 212 proceeds. The control unit 14 is configured not to determine the detection of the reflected electromagnetic wave 210 on the basis of the detection result output by the detection elements 22 into which the first detection electromagnetic wave 212 does not proceed. Likewise, the control unit 14 is configured not to determine the detection of the reflected electromagnetic wave 210 on the basis of the detection result output by the detection elements 22 on which the first detection electromagnetic wave 212 (the reflected electromagnetic wave 210) is not incident when the first detection electromagnetic wave 212 (the reflected electromagnetic wave 210) proceeds into the first detection module 20. This will be described in more detail below. When an electromagnetic wave is incident on any of the detection elements 22, the detection result in the form of a detection signal is output to the control unit 14. Electromagnetic waves from the space in which the detection target ob is present are incident on the detection elements 22 of the first detection module 20. The control unit 14 receives a detection signal from the detection element 22 into which the reflected electromagnetic wave 210 proceeds; that is, upon receipt of the detection signal, the control unit 14 determines that the detection result denotes the detection of the reflected electromagnetic wave 210. Meanwhile, the control unit 14 does not receive detection signals from the other detection elements 22. When performing processing based on detection signals, the control unit 14 may use only detection signals from the detection element 22 into which the reflected electromagnetic wave 210 proceeds. When being designed to serve as a distance meter, the electromagnetic wave detection apparatus 10 determines the distance between the detection target ob and the observation point on the basis of a detection signal from the detection element 22 into which the reflected electromagnetic wave 210 proceeds. That is, detection signals from the other detection elements 22 are not used for the measurement of the distance. The detection element 22 toward which the reflected electromagnetic wave 210 proceeds can be determined by using a table that will be described later. The control unit 14 receives the detection result in a selective manner and is thus less likely to receive result that denotes the detection of electromagnetic waves other than the reflected electromagnetic wave 210. The detection result received by the control unit 14 and denoting the detection of the reflected electromagnetic wave 210 may thus be less affected by noise.

The control unit 14 operates in the following manner such that the control unit 14 does not determine the detection of the reflected electromagnetic wave 210 on the basis of the detection result output by the detection elements 22 into which the first detection electromagnetic wave 212 does not proceed. For example, the control unit 14 may be configured not to receive the detection result from the detection elements 22 into which the first detection electromagnetic wave 212 does not proceed. In other words, the control unit 14 may be configured not to receive the detection result from the detection elements 22 into which the first detection electromagnetic wave 212 does not proceed. Under the control of the control unit 14, the detection elements 22 into which the first detection electromagnetic wave 212 proceeds may output detection result, whereas the detection elements 22 into which the first detection electromagnetic wave 212 does not proceed may be kept from outputting detection result. Alternatively, the control unit 14 may be configured to receive the detection result output by the detection elements 22 into which the first detection electromagnetic wave 212 does not proceed; nevertheless, the control unit 14 may be configured not to determine the detection of the reflected electromagnetic wave 210 on the basis of the detection result concerned.

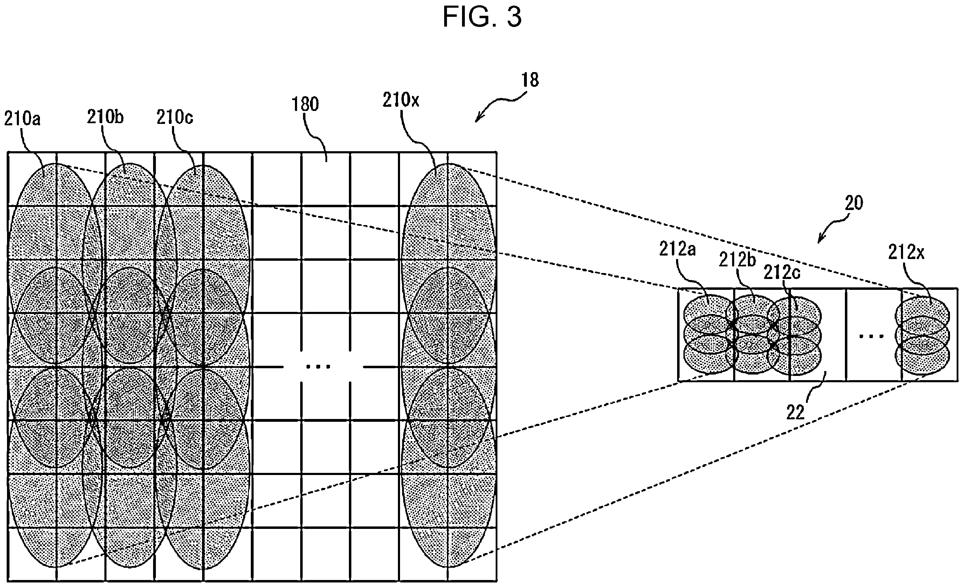

FIG. 3 illustrates the positional relationship between some of the propagation elements 180 and some of the detection elements 22. The reflected electromagnetic wave 210 is incident on the propagation elements 180 concerned. The propagation elements 180 in the first state redirect the course of the reflected electromagnetic wave 210, which is in turn incident on the detection elements 22 concerned. The first image-forming module 15 causes the reflected electromagnetic wave 210 to form imagery on the propagation module 18. Referring to FIG. 3, electromagnetic waves respectively denoted by 210a, 210b, 210c, and 210x are illustrated as imagery. As illustrated in FIG. 3, the reflected electromagnetic wave 210 incident on the propagation elements 180 of the propagation module 18 corresponds to the first detection electromagnetic wave 212 incident on the detection elements 22 of the first detection module 20 from the propagation module 18. In other words, when the first detection electromagnetic wave 212 is incident on the propagation elements 180 in the first state, the propagation elements 180 concerned causes the first detection electromagnetic wave 212 to proceed toward the predetermined detection elements 22. For example, the reflected electromagnetic wave 210a proceeding into the propagation module 18 corresponds to the first detection electromagnetic wave proceeding into the first detection module 20. The first detection electromagnetic wave concerned is denoted by 212a. Likewise, the first detection electromagnetic waves to which the reflected electromagnetic waves 210b, 210c, and 210x correspond are denoted by 212b, 212c, and 212x, respectively.

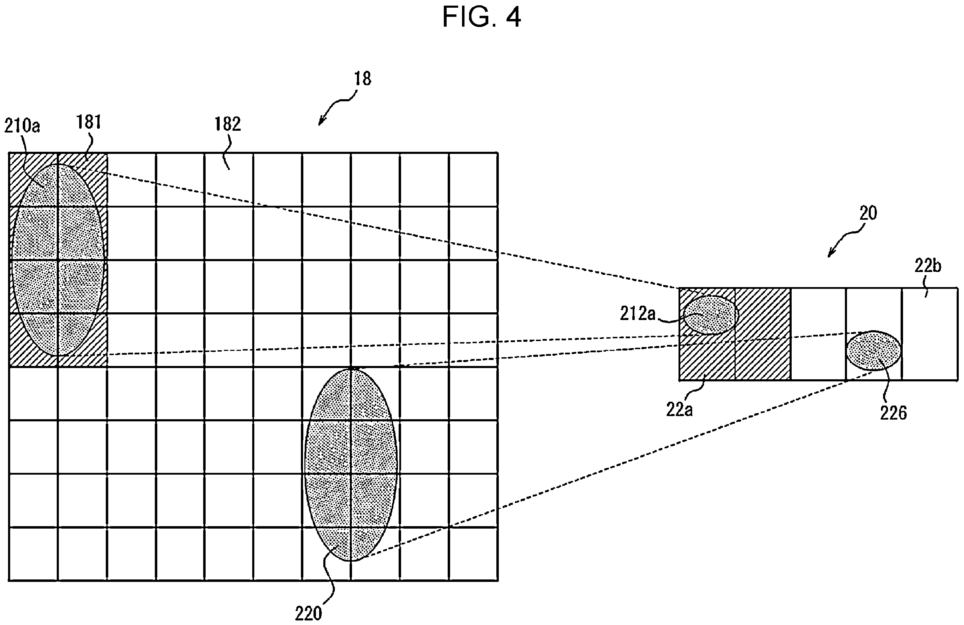

The control unit 14 controls the state of each propagation element 180 on the basis of the position of the propagation module 18 into which the reflected electromagnetic wave 210 proceeds. Furthermore, the control unit 14 makes a judgement as to the disposition of the detection result output by each detection element 22 of the first detection module 20. The following describes the workings of the control unit 14 with reference to FIG. 4.

The reflected electromagnetic wave 210a is incident on some of the propagation elements 180 of the propagation module 18 or, more specifically, on the propagation elements 180 that are located in the first and second columns counting from the left side in FIG. 4 and in the first to fourth rows counting from the upper side in FIG. 4. The propagation elements 180 toward which the reflected electromagnetic wave 210a proceeds are caused to transition into the first state in advance by the control unit 14. In other words, the propagation elements 180 into which the reflected electromagnetic wave 210 proceeds are designated as the first propagation elements 181 by the control unit 14. The first propagation elements 181 are represented by hatched cells. The propagation elements 180 into which the reflected electromagnetic wave 210 does not proceed are caused to transition into the second state by the control unit 14. In other words, the propagation elements 180 into which the reflected electromagnetic wave 210 proceeds are designated as the second propagation elements 182 by the control unit 14. The second propagation elements 182 are represented by cells that are not hatched.

The background electromagnetic wave 220, which is different from the reflected electromagnetic wave 210a, can be incident on the second propagation elements 182. The second propagation elements 182 cause the incoming electromagnetic wave to veer away from the first detection module 20. Accordingly, the background electromagnetic wave 220 is less likely to proceed into the first detection module 20. This reduces the possibility that the noise caused by the background electromagnetic wave 220 will affect the result denoting the detection of the reflected electromagnetic wave 210a.

Referring to FIG. 4, the reflected electromagnetic wave 210a incident on the first propagation elements 181 proceeds into the first detection module 20 and is thus regarded as the first detection electromagnetic wave 212a. The first detection electromagnetic wave 212a is incident on some of the detection elements 22 of the first detection module 20 or, more specifically, on the detection elements 22 that are located in the first and second columns counting from the left side. The detection elements 22 on which the first detection electromagnetic wave 212a is incident are hereinafter also referred to as detection elements 22a and are represented by hatched cells. The detection elements 22 on which the first detection electromagnetic wave 212a is not incident are hereinafter also referred to as detection elements 22b and are represented by cells that are not hatched.

The control unit 14 determines the detection of the reflected electromagnetic wave 210a on the basis of the detection result output by the detection elements 22a into which the first detection electromagnetic wave 212a proceeds. Meanwhile, the control unit 14 does not determine the detection of the reflected electromagnetic wave 210a on the basis of the detection result output by the detection elements 22b into which the first detection electromagnetic wave 212a does not proceed. It is not required that the control unit 14 be configured to receive the detection result output by the detection elements 22b. Under the control of the control unit 14, the detection elements 22b may be configured not to output the detection result. In other words, the state of the detection elements 22a into which the first detection electromagnetic wave 212 proceeds may be switched by the control unit 14 such that the detection elements 22a are prompted to output the detection result. The state of the detection elements 22b into which the first detection electromagnetic wave 212 does not proceed may be switched by the control unit 14 such that the detection elements 22b are kept from outputting the detection result. Not all of the detection elements 22 into which the first detection electromagnetic wave 212 proceeds may be prompted to output the detection result. One or more detection elements 22 at which the irradiation amount of the first detection electromagnetic wave 212 is greater than a predetermined value may be prompted to output the detection result. Likewise, not all of the detection elements 22 into which the first detection electromagnetic wave 212 does not proceed may be kept from outputting the detection result. One or more detection elements 22 at which the irradiation amount of the first detection electromagnetic wave 212 is less than the predetermined value may be kept from outputting the detection result.

The background electromagnetic wave 220 incident on the second propagation elements 182 may partially proceed into the first detection module 20 due to, for example, scattering and may thus be regarded as the noise electromagnetic wave 226. However, the detection of the reflected electromagnetic wave 210a is not determined on the basis of the detection result output by the detection elements 22b. This reduces the possibility that the noise caused by the noise electromagnetic wave 226 will affect the result denoting the detection of the reflected electromagnetic wave 210a.

The electromagnetic wave detection apparatus 10 is configured to designate, on the basis of the emission direction of the emission electromagnetic wave 200, the propagation elements 180 into which the reflected electromagnetic wave 210 proceeds and the detection elements 22 into which the first detection electromagnetic wave 212 proceeds. The control unit 14 may select, on the basis of the emission direction of the emission electromagnetic wave 200, which propagation elements 180 to designate as the first propagation elements 181 and which propagation elements 180 to designate as the second propagation elements 182. The control unit 14 may switch, on the basis of the selection it has made, the state of each propagation element 180 in advance of the emission of electromagnetic waves from the radiation unit 12. For each of the detection elements 22, the control unit 14 may determine, on the basis of the emission direction of the emission electromagnetic wave 200, whether the first detection electromagnetic wave 212 proceeds into the detection element 22 concerned. On the basis of the determination, the control unit 14 may make a judgement as to the disposition of the detection result output by each detection element 22.

The control unit 14 may obtain in advance a table denoting the correspondence between the emission direction of the emission electromagnetic wave 200 and the detection elements 22 into which the reflected electromagnetic wave 210 generated by the return of the emission electromagnetic wave 200 from the detection target ob proceeds. The control unit 14 may store the table in a storage unit. For each of the detection elements 22, the control unit 14 may determine, with reference to the table, whether the first detection electromagnetic wave 212 proceeds into the detection element 22 concerned.

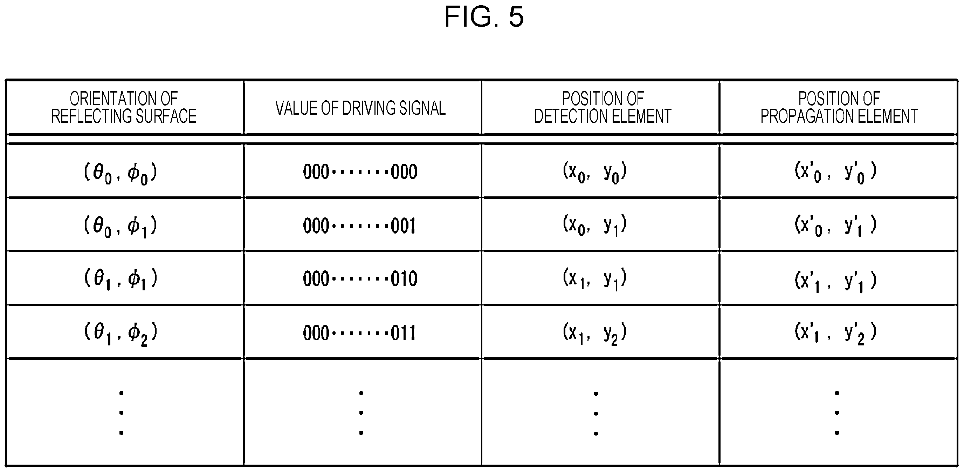

FIG. 5 is an example of the table that may be obtained by the control unit 14. The example table in FIG. 5 denotes the correspondence between the orientation of the scanning reflecting surface (see the first column counting from the left) and the position of each of the detection elements 22 (see the third column counting from the left). The orientation of the scanning reflecting surface dictates the emission direction of the emission electromagnetic wave 200. Thus, the example table in FIG. 5 denotes the correspondence between the emission direction of the emission electromagnetic wave 200 and the detection elements 22 into which the first detection electromagnetic wave 212 generated from the emission electromagnetic wave 200 proceeds. Referring to the table, the orientation of the scanning reflecting surface is defined by two angles denoted by 0 and ϕ that specify a direction in the spherical coordinate system. Each of the detection elements 22 is represented by the x coordinate and the y coordinate that indicate the position in a planar coordinate system for the detection surface 20a of the first detection module 20. The control unit 14 can determine, with reference to the example table in FIG. 5, which detection element 22 the first detection electromagnetic wave 212 proceeds into.

The correspondence between the orientation of the scanning reflecting surface (see the first column counting from the left) and the value of a driving signal applied to the scanning unit 13 (see the second column counting from the left) is also denoted by the example table in FIG. 5. The value of the driving signal corresponds to the value of a signal that is output to the radiation unit 12 or the scanning unit 13 for the purpose of controlling the orientation of the scanning reflecting surface. The value of the driving signal in the table is obtained by counting in binary. The control unit 14 may control the scanning unit 13 with reference to the example table in FIG. 5 such that the emission direction of the emission electromagnetic wave 200 coincides with a predetermined direction.

The correspondence between the orientation of the scanning reflecting surface (see the first column counting from the left) and the position of each of the propagation elements 180 (see the fourth column counting from the left) is also denoted by the example table in FIG. 5. Each of the propagation elements 180 in the table is represented by the x coordinate and the y coordinate that indicate the position in a planar coordinate system for the reference plane 18a of the propagation module 18. The letters representing the coordinates of the propagation elements 180 are marked with the prime symbol ' used to differentiate them from the letters representing the coordinates of each of the detection elements 22. The control unit 14 can determine, with reference to the example table in FIG. 5, which propagation element 180 the reflected electromagnetic wave 210 proceeds into.

As mentioned above, the control unit 14 can determine, with reference to the table in FIG. 5, which detection element 22 the first detection electromagnetic wave 212 proceeds into. This may take some of the processing load off the control unit 14.

### <Flowchart of Procedure Adopted into Electromagnetic Wave Detection Method>

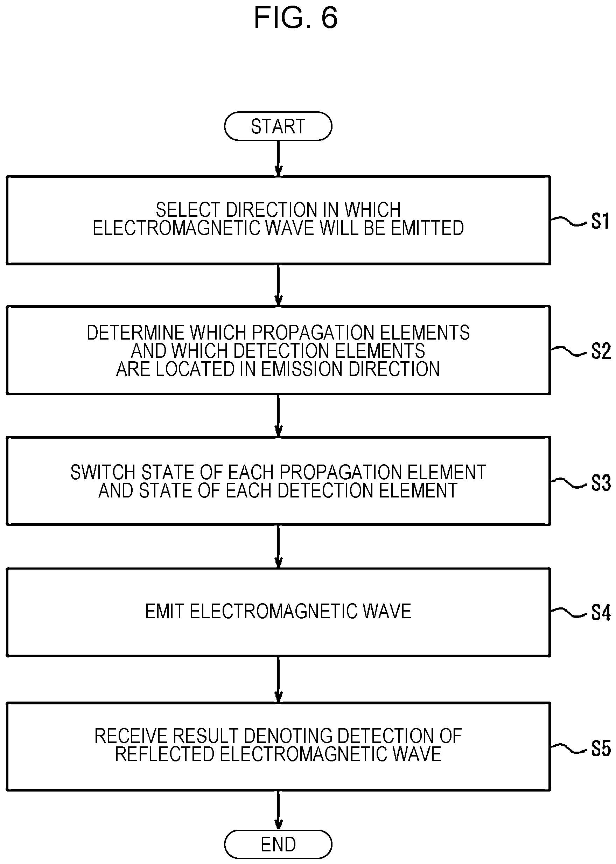

The control unit 14 of the electromagnetic wave detection apparatus 10 may execute an electromagnetic wave detection method into which the procedure illustrated in FIG. 6 is adopted. The electromagnetic wave detection method may be an electromagnetic wave detection program that is to be executed by the processor included in the control unit 14. The electromagnetic wave detection program may be stored in a non-transitory computer-readable medium.

The control unit 14 selects a direction in which the emission electromagnetic wave 200 will be emitted (Step S 1).

The control unit 14 determines which propagation elements 180 and which detection elements 22 are located in the emission direction of the emission electromagnetic wave 200 (Step S2). The control unit 14 may determine which propagation elements 180 the reflected electromagnetic wave 210 proceeds into. Likewise, the control unit 14 may determine which detection elements 22 the first detection electromagnetic wave 212 proceeds into.

The control unit 14 switches the state of the relevant propagation elements 180 and the relevant detection elements 22 (Step S3). The propagation elements 180 into which the reflected electromagnetic wave 210 proceeds are caused to transition into the first state by the control unit 14, whereas the propagation elements 180 into which the reflected electromagnetic wave 210 does not proceed are caused to transition into the second state by the control unit 14. The state of the detection elements 22 into which the first detection electromagnetic wave 212 proceeds may be switched by the control unit 14 such that the detection elements 22 are prompted to output the detection result. The state of the detection elements 22 into which the first detection electromagnetic wave 212 does not proceed may be switched by the control unit 14 such that the detection elements 22 are kept from outputting the detection result.

The control unit 14 controls the radiation unit 12 and the scanning unit 13 such that the emission electromagnetic wave 200 is emitted in the direction selected in Step S1 (Step S4). The control unit 14 may control the orientation of the scanning reflecting surface of the scanning unit 13 in accordance with the selected direction.

The control unit 14 receives the result denoting the detection of the reflected electromagnetic wave 210 generated by reflection on the detection target ob (Step S5). After performing Step S5, the control unit 14 ends the procedure illustrated in the flowchart in FIG. 6. After performing Step S5, the control unit 14 may return to Step S 1.

### <Brief Summary>

The present embodiment described above is summarized as follows. The electromagnetic wave detection apparatus 10 emits the emission electromagnetic wave 200 to the detection target ob and detects the reflected electromagnetic wave 210 generated by reflection on the detection target ob. Accordingly, the electromagnetic wave detection apparatus 10 acquires information about the detection target ob.

The control unit 14 of the electromagnetic wave detection apparatus 10 receives the detection result from the detection elements 22 of the first detection module 20 in a selective manner and determines the detection of the reflected electromagnetic wave 210 on the basis of the detection result. To be more specific, the control unit 14 is configured to determine the detection of the reflected electromagnetic wave 210 on the basis of the detection result output by the detection elements 22 into which the reflected electromagnetic wave 210 proceeds. Meanwhile, the control unit 14 does not to determine the detection of the reflected electromagnetic wave 210 on the basis of the detection result output by the detection elements 22 into which the reflected electromagnetic wave 210 does not proceed. The background electromagnetic wave 220 and other electromagnetic waves different from the reflected electromagnetic wave 210 can proceed into the first detection module 20; nevertheless, the detection result concerning the background electromagnetic wave 220 or the other electromagnetic waves may be disregarded. The result denoting the detection of the reflected electromagnetic wave 210 is received in a selective manner. This reduces the noise that will affect the result denoting the detection of the reflected electromagnetic wave 210.

Under the control of the control unit 14, the propagation module 18 causes the reflected electromagnetic wave 210 to proceed into the first detection module 20, whereas the background electromagnetic wave 220 and other electromagnetic waves different from the reflected electromagnetic wave 210 are less likely to proceed into the first detection module 20. Accordingly, electromagnetic waves that can cause noise are less likely to proceed into the first detection module 20. This reduces the noise that will affect the result denoting the detection of the reflected electromagnetic wave 210 in the first detection module 20.

### (Variations)

The following describes variations of the constituent components of the electromagnetic wave detection apparatus 10.

### <Propagation Module 18>

The propagation module 18 may include a mirror device, such as a digital micromirror device (DMD) or a micro-electro-mechanical-systems (MEMS) mirror. The propagation elements 180 may be mirror elements. The mirror elements may be arranged along the reference plane 18a.

The propagation elements 180 each may have a reflecting surface that reflects electromagnetic waves incident on the reference plane 18a. The propagation module 18 may control the orientation of the reflecting surface of each propagation element 180 to select a direction in which the electromagnetic waves incident the reference plane 18a will be reflected. The reflecting surfaces of the propagation elements 180 may be oriented in the directions respectively corresponding to the first state and the second state. That is, the reflecting surface of each propagation element 180 in the first state and the reflecting surface of each propagation element 180 in the second state may be oriented in different directions. Accordingly, the propagation module 18 selects a direction in which electromagnetic waves will be reflected. The first state may correspond to a first reflection state in which electromagnetic waves are reflected in a first direction. The second state may correspond to a second reflection state in which electromagnetic waves are reflected in a second direction.

The propagation elements 180 each may include a shutter having a reflecting surface that reflects electromagnetic waves. When the shutters of the propagation elements 180 are open, electromagnetic waves pass through the propagation elements 180 and proceeds in a predetermined direction. The state in which the shutters are open corresponds to the first state. When the shutters of the propagation elements 180 are closed, electromagnetic waves are reflected on the propagation elements 180 and proceeds in a direction different from the predetermined direction. The state in which the shutters are closed corresponds to the second state. The propagation elements 180 each may include a shutter; that is, the propagation module 18 may include an array of MEMS shutters arranged along the reference plane 18a and may be capable of controlling the opening and closing of the propagation elements 180.

The propagation elements 180 each may include a liquid crystal shutter. The liquid crystal shutter controls the alignment state of liquid crystals such that the liquid crystals are to transition into the transmission state or the reflection state, where transmission of electromagnetic waves is allowed in the transmission state, and electromagnetic waves are reflected in the reflection state. The transmission state and the reflection state correspond to the first state and the second state, respectively.

### <First Detection Module 20>

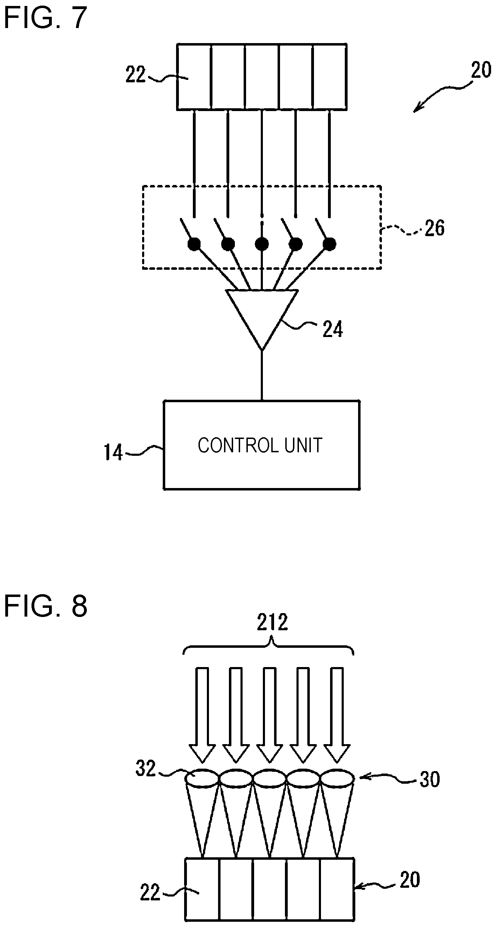

The first detection module 20 may include a mechanism by which the detection result is output to the control unit 14 in a selective manner. As illustrated in FIG. 7, the first detection module 20 may further include an amplifier 24 and a switch 26. The amplifier 24 outputs the detection result to the control unit 14. The switch 26 is connected between the amplifier 24 and the detection elements 22. When the switch 26 is on, signals from the detection elements 22 are output to the amplifier 24. When the switch 26 is off, signals from the detection elements 22 are not output to the amplifier 24. That is, when the switch 26 is on, the detection elements 22 connected to the switch 26 are ready to output the detection result. When the switch 26 is off, the detection elements 22 connected to the switch 26 are kept from outputting the detection result. In other words, the switch 26 performs switching on each detection element 22 to enable and disable the output of the detection result. The control unit 14 turns on or off the switch 26 to switch the state of each detection element 22.

The detection elements 22 of the first detection module 20 may each be capable of switching between ON state and OFF state. The detection elements 22 in the ON state outputs signals corresponding to incoming electromagnetic waves. The detection elements 22 in the OFF state are kept from outputting signals irrespective of the presence or absence of incoming electromagnetic waves. The control unit 14 may cause the detection elements 22 to transition into the ON state such that the detection elements 22 output the detection result to the amplifier 24. The control unit 14 may cause the detection elements 22 to transition into the OFF state such that the detection elements 22 are kept from outputting the detection result to the amplifier 24.

The control unit 14 may turn on two detection elements 22 at a time, with the other detection elements 22 remaining turned off. Signals output as the detection result by the first detection module 20 may thus be stabilized, with the signal intensity being equal to or greater than a predetermined value. It is not required that two detection elements 22 be turned on at a time. The number of detection elements to be turned on at a time may be changed in accordance with the circuit configuration.

As illustrated in FIG. 8, the first detection module 20 may include a microlens array 30. The microlens array 30 include multiple microlenses 32. Each of the microlenses 32 may be provided for the corresponding one of the detection elements 22. Each microlens 32 may be configured to cause the incoming first detection electromagnetic wave 212 to converge into the corresponding detection elements 22. These features enable the detection elements 22 to detect the first detection electromagnetic wave 212 with a higher degree of efficiency. The noise that will affect the result denoting the detection of the reflected electromagnetic wave 210 (the first detection electromagnetic wave 212) may be reduced accordingly.

For example, the detection elements 22 of the first detection module 20 may each include an avalanche photodiode (APD), a photodiode (PD), or a single-photon avalanche diode (SPAD). The detection elements 22 may each include a millimeter-wave sensor, a submillimeter-wave sensor, or a distance-measuring image sensor.

The detection elements 22 may be arranged in a line or in a two-dimensional array.

The first detection module 20 may be a distance-measuring sensor. The electromagnetic wave detection apparatus 10 can acquire distance information provided in the form of an image by the first detection module 20 serving as a distance-measuring sensor.

The control unit 14 may acquire distance information from the first detection module 20 serving as a distance-measuring sensor. The control unit 14 may acquire the distance information about the detection target ob by using time-of-flight (ToF) methods on the basis of the detection result received from the first detection module 20. An example of the ToF methods that may be used by the control unit 14 is Direct ToF, which works by emitting an electromagnetic wave and measuring, directly, the amount of time between the emission of the electromagnetic wave and the detection of the reflected wave. Another example of the ToF methods that may be used by the control unit 14 is Flash ToF, which works by emitting an electromagnetic wave at regular intervals and measuring, indirectly, the amount of time between the emission of the electromagnetic wave and the detection of the reflected wave on the basis of the phase of the emitted electromagnetic wave and the phase of the reflected wave. Still another example of the ToF method that may be used by the control unit 14 is Phased ToF. The control unit 14 may conduct the ToF measurement by causing the radiation unit 12 to emit an electromagnetic wave.

For example, the control unit 14 may include a time-measuring large-scale integrated circuit (LSI). The control unit 14 may determine the response time by calculating the amount of time between the emission of an electromagnetic wave from the radiation unit 12 and the detection of the electromagnetic wave at the first detection module 20 following the reflection of the electromagnetic wave on the detection target ob. The control unit 14 may determine, by calculation, the distance between the detection target ob and the observation point on the basis of the response time. For example, the control unit 14 causes the radiation unit 12 or the scanning unit 13 to scan the detection target ob with an electromagnetic wave, in which case the control unit 14 may obtain the distance information in the form of an image by synchronizing the emission direction of the electromagnetic wave with the detection result received from the first detection module 20.

The control unit 14 may acquire temperature information from the first detection module 20 serving as a thermo-sensor. The control unit 14 may acquire information about surroundings of the electromagnetic wave detection apparatus 10 on the basis of the result received from the first detection module 20 and denoting the detection of an electromagnetic wave. The information about the surroundings may include at least one of image information, distance information, or temperature information.

### <Prism 16>

The transmittance or reflectance of the reflecting surface 16a of the prism 16 may vary according to the wavelength of the incident electromagnetic wave. The transmittance or reflectance of the reflecting surface 16a may vary depending on where the incident electromagnetic wave comes from, that is, depending whether the incident electromagnetic wave strikes on the reflecting surface 16a from the outside or inside of the prism 16.

Electromagnetic waves may be reflected by the reflecting surface 16a with predetermined reflectance. In a case where the reflectance is kept at a predetermined value irrespective of the wavelength of electromagnetic waves, the imagery formed on the detection surface of the second detection module 17 may be a direct consequence of changing, at a predetermined rate, the intensity of the electromagnetic wave forming the imagery as a whole on the reference plane 18a of the propagation module 18.

For example, when an electromagnetic wave whose wavelength is within a predetermined range is incident on the reflecting surface 16a, the reflectance of the reflecting surface 16a may be equal to or greater than a predetermined value. When an electromagnetic wave whose wavelength is outside the predetermined range is incident on the reflecting surface 16a, the reflectance of the reflecting surface may be less than the predetermined value. Thus, electromagnetic waves whose wavelengths are outside the predetermined range are more likely to be reflected toward the second detection module 17 and proceed into the second detection module 17. Meanwhile, electromagnetic waves whose wavelengths are outside the predetermined range are more likely to pass through the reflecting surface 16a and proceed into the propagation module 18. Accordingly, electromagnetic waves may be sorted by wavelength. That is, electromagnetic waves incident on the reflecting surface 16a can be sorted by wavelength. The lower limit of the predetermined range may be equal to or greater than a predetermined wavelength. The upper limit of the predetermined range may be equal to or less than a predetermined wavelength. The lower limit of the predetermined range may be a first predetermined wavelength, and the upper limit of the predetermined range may be a second predetermined wavelength. Alternatively, the first predetermined wavelength may be the upper limit of the predetermined range, and the second predetermined wavelength may be the lower limit of the predetermined range.

When electromagnetic waves of different wavelengths are incident on the reflecting surface 16a and are sorted by wavelength, coordinates describing the imagery formed on the detection surface of the second detection module 17 coincide with coordinates describing the imagery formed on the reference plane 18a of the propagation module 18. While the second detection module 17 obtains image information, the first detection module 20 obtains image information, distance information in the form of an image, or temperature information in the form of an image. When the coordinates describing the imagery formed on the detection surface of the second detection module 17 coincide with the coordinates describing the imagery formed on the reference plane 18a of the propagation module 18, the image information obtained by the first detection module 20 can be easily superposed on the image information obtained by the second detection module 17. This feature or, more specifically, sorting electromagnetic waves by wavelength on the reflecting surface 16a enables the first detection module 20 and the second detection module 17 to serve as sensors that detect waves of the respective wavelength ranges.

The reflecting surface 16a may include at least one of a visible light reflective coating, a half mirror, a beam splitter, a dichroic mirror, a cold mirror, a hot mirror, a metasurface, or a deflection element.

### <Second Detection Module 17>

The second detection module 17 may include an array of detection elements arranged along the detection surface. For example, the second detection module 17 may include an imaging device, such as an image sensor or an imaging array. The second detection module 17 including the imaging device may capture imagery formed by electromagnetic waves incident on the detection surface and generate image information on the basis of the imagery.

The second detection module 17 capture imagery formed by visible light. The second detection module 17 may capture imagery formed by radiation other than visible light. For example, the second detection module 17 may capture imagery formed by infrared light, ultraviolet light, or a radio wave. The second detection module 17 may include a distance-measuring sensor. The electromagnetic wave detection apparatus 10 can acquire distance information provided in the form of an image by the second detection module 17 including a distance-measuring sensor. The second detection module 17 may include a thermo-sensor. The electromagnetic wave detection apparatus 10 can acquire temperature information provided in the form of an image by the second detection module 17 including a thermo-sensor.

The second detection module 17 may include a single detection element. For example, the single detection element may include an avalanche photodiode (APD), a photodiode (PD), or a single-photon avalanche diode (SPAD). The single detection element may include a millimeter-wave sensor, a submillimeter-wave sensor, or a distance-measuring image sensor. The second detection module 17 may include a detection element array. Examples of the detection element array include an APD array, a PD array, a multi-photon pixel counter (MPPC), a distance-measuring imaging array, and a distance-measuring image sensor.

Although the present disclosure has been described above with reference to the accompanying drawings and by means of examples, various alterations or modifications can be made on the basis of the present disclosure by those skilled in the art. It is to be understood that such alterations and modifications fall within the scope of the present disclosure. For example, functions and the like of each functional unit can be rearranged in any way that involves no logical inconsistency. The functional units can be combined into one or divided. It is not required that the embodiments of the present disclosure be implemented with a high degree of fidelity to what has been described above. Where appropriate, the embodiments may be implemented with the respective features used in combination, and or some of the features may be omitted.

The words "first", "second", and so on in the present disclosure are identifiers for distinguishing between constituent elements. With the constituent elements being distinguishable by "first", "second", and so on in the present disclosure, the identifiers assigned to these constituent elements are interchangeable. For example, the identifier "first" assigned to the first image-forming module 15 and the identifier "second" assigned to the second image-forming module 19 are interchangeable. The identifiers are to be interchanged all at once. The constituent elements remain distinguishable from each other after interchanges of identifiers. The identifiers may be omitted. Constituent elements from which the identifiers are omitted are distinguished by reference signs. In the present disclosure, the identifiers "first", "second" and so on are not be used for interpretation of the order of the constituent elements or are not be used as grounds for the presence of lower numbered identifiers.

### REFERENCE SIGNS

10 electromagnetic wave detection apparatus (12 radiation unit; 13 scanning unit; 14 control unit)
11 detection unit (15 first image-forming module; 19 second image-forming module)
16 prism (16a reflecting surface)
17 second detection module
18 propagation module (18a reference plane; 180 propagation element; 181 first propagation element; 182 second propagation element)
20 first detection module (20a detection surface, 22 detection element, 24 amplifier; 26 switch)
30 microlens array (32 microlens)
200 emission electromagnetic wave
210 (210a, 210b, 210c, 212x) reflected electromagnetic wave
212 (212a, 212b, 212c, 212x) first detection electromagnetic wave
220 background electromagnetic wave
222 second detection electromagnetic wave
224 undetected electromagnetic wave
226 noise electromagnetic wave
ob detection target

## Claims

1. An electromagnetic wave detection apparatus, comprising:
a radiation unit configured to emit an emission electromagnetic wave to a space in which a detection target is present;
a first detection module comprising a plurality of detection elements configured to output result denoting detection of a reflected electromagnetic wave generated by return of the emission electromagnetic wave from the detection target;
a propagation module comprising a plurality of propagation elements capable of switching between a first state and a second state, the reflected electromagnetic wave being caused to proceed toward the first detection module by the plurality of propagation elements in the first state and being kept from proceeding toward the first detection module by the plurality of propagation elements in the second state;
a control unit configured to cause a first propagation element included in the plurality of propagation elements to transition into the first state and to cause a second propagation element included in the plurality of propagation elements to transition into the second state, the reflected electromagnetic wave proceeding into the first propagation element and not proceeding into the second propagation element, wherein
the control unit is configured
to determine, based on detection result output by at least one of the plurality of detection elements into which the reflected electromagnetic wave proceeds, the detection of the reflected electromagnetic wave, and
not to determine, based on detection result output by at least one of the plurality of detection elements into which the reflected electromagnetic wave does not proceed, the detection of the reflected electromagnetic wave.

2. An electromagnetic wave detection apparatus, comprising:
a radiation unit configured to emit an emission electromagnetic wave to a space in which a detection target is present;
a first detection module comprising a plurality of detection elements configured to output result denoting detection of an electromagnetic wave incident from the space; and
a control unit configured
to determine, based on detection result output by at least one of the plurality of detection elements into which a reflected electromagnetic wave generated by return of the emission electromagnetic wave from the detection target proceeds, the detection of the reflected electromagnetic wave, and
not to determine, based on detection result output by at least one of the plurality of detection elements into which the reflected electromagnetic wave does not proceed, the detection of the reflected electromagnetic wave.

3. The electromagnetic wave detection apparatus according to claim 1 or 2, wherein the at least one of the plurality of detection elements into which the reflected electromagnetic wave proceeds is caused to output detection result by the control unit, and
the at least one of the plurality of detection elements into which the reflected electromagnetic wave does not proceed is kept from outputting detection result by the control unit.

4. The electromagnetic wave detection apparatus according to claim 1 or 2, wherein the control unit is configured not to receive detection result output by the at least one of the plurality of detection elements into which the reflected electromagnetic wave does not proceed.

5. The electromagnetic wave detection apparatus according to any one of claims 1 to 4, wherein
the first detection module comprises a switch configured to enable and disable output of the detection result from each of the plurality of detection elements, and
with the switch placed under control of the control unit, detection result output by the at least one of the plurality of detection elements into which the reflected electromagnetic wave proceeds is received by the control unit whereas detection result output by the at least one of the plurality of detection elements into which the reflected electromagnetic wave does not proceed is not received by the control unit.

6. The electromagnetic wave detection apparatus according to any one of claims 1 to 5, wherein the control unit determines, based on an emission direction of the emission electromagnetic wave, which detection element the reflected electromagnetic wave proceeds into.

7. The electromagnetic wave detection apparatus according to claim 6, further comprising a storage unit configured to store correspondence between the emission direction of the emission electromagnetic wave and the at least one of the plurality of detection elements into which the reflected electromagnetic wave proceeds, wherein
the control unit determines, based on the correspondence, which detection elements the reflected electromagnetic wave proceeds into.

8. The electromagnetic wave detection apparatus according to any one of claims 1 to 7, further comprising a microlens array configured to cause the reflected electromagnetic wave proceeding toward the first detection module to converge into the plurality of detection elements.

9. The electromagnetic wave detection apparatus according to any one of claims 1 to 8, wherein the control unit is configured not to determine, based on detection result output by the at least one of the plurality of detection elements on which the reflected electromagnetic wave is not incident when the reflected electromagnetic wave proceeds into the first detection module, the detection of the reflected electromagnetic wave.

10. The electromagnetic wave detection apparatus according to any one of claims 1 to 9, wherein distance between the detection target and an observation point is measured based on the detection result serving as a basis for determining the detection of the reflected electromagnetic wave.

11. An electromagnetic wave detection method, comprising:
emitting an emission electromagnetic wave to a space in which a detection target is present;
causing a plurality of propagation elements included in a propagation module to undergo switching between two states, the propagation module being configured to cause a reflected electromagnetic wave generated by return of the emission electromagnetic wave from the detection target to proceed toward a first detection module comprising a plurality of detection elements and configured to detect the reflected electromagnetic wave, the switching comprising causing a first propagation element included in the plurality of propagation elements to transition into a first state in which the reflected electromagnetic wave is caused to proceed toward the first detection module and causing a second propagation element included in the plurality of propagation elements to transition into a second state in which the reflected electromagnetic wave is kept from proceeding toward the first detection module, the reflected electromagnetic wave proceeding into the first propagation element and not proceeding into the second propagation element;
determining, based on detection result output by at least one of the plurality of detection elements into which the reflected electromagnetic wave proceeds, detection of the reflected electromagnetic wave; and
not determining, based on detection result output by at least one of the plurality of detection elements into which the reflected electromagnetic wave does not proceed, detection of the reflected electromagnetic wave.

12. An electromagnetic wave detection method, comprising:
emitting an emission electromagnetic wave to a space in which a detection target is present;
determining, based on detection result output by at least one of a plurality of detection elements included in a first detection module configured to detect an electromagnetic wave incident from the space, detection of a reflected electromagnetic wave generated by return of the emission electromagnetic wave from the detection target when the reflected electromagnetic wave proceeds into the at least one of the plurality of detection elements; and
not determining, based on detection result output by at least one of the plurality of detection elements into which the reflected electromagnetic wave does not proceed, the detection of the reflected electromagnetic wave.
